# EUROPÄISCHE PATENTSCHRIFT

(11) **EP 0 695 033 B1**
(45) Veröffentlichungstag und Bekanntmachung des Hinweises auf die Patenterteilung: **24.03.2004**
(21) Anmeldenummer: 95110346.4
(22) Anmeldetag: 03.07.1995
(51) Int. Cl.: H03K 3/013

(54) **Schaltungsanordnung zur Störsignalunterdrückung**
Circuit arrangement for interference signal suppression
Montage pour la suppression de signaux parasites

(30) Priorität: 29.07.1994 DE 4427015
(43) Veröffentlichungstag der Anmeldung: 31.01.1996
(73) Patentinhaber: Infineon Technologies AG, 81669 München (DE)
(72) Erfinder: Kirchhoff, Hans-Gerd, Dipl.-Ing., D-40885 Ratingen-Lintorf (DE)
(74) Vertreter: Jannig, Peter, Dipl.-Ing.

(56) Entgegenhaltungen:
- GB-A- 2 030 404
- US-A- 4 908 528
- RADIO FERNSEHEN ELEKTRONIK, Bd. 32, Nr. 4, 1983 BERLIN DE, Seiten 207-211, BÜHN 'Verbesserung der Störsicherheit elektronischer Geräte'
- IBM TECHNICAL DISCLOSURE BULLETIN, Bd. 27, Nr. 11, April 1985 NEW YORK US, Seiten 6391-6392, 'ORGANELLE FOR LOGICALLY GROWABLE DATA SPACES'

## Beschreibung

Die Erfindung betrifft eine Schaltungsanordnung zur Störsignalunterdrückung, die eine Schaltung mit zwei von einer Eingangssignalklemme gesteuerten Eingängen aufweist, wobei jedem der Eingänge jeweils ein Transfergatter in Reihe vorgeschaltet ist und wobei parallel zu jedem Eingang ein als Kapazität geschalteter Transistor vorgesehen ist.

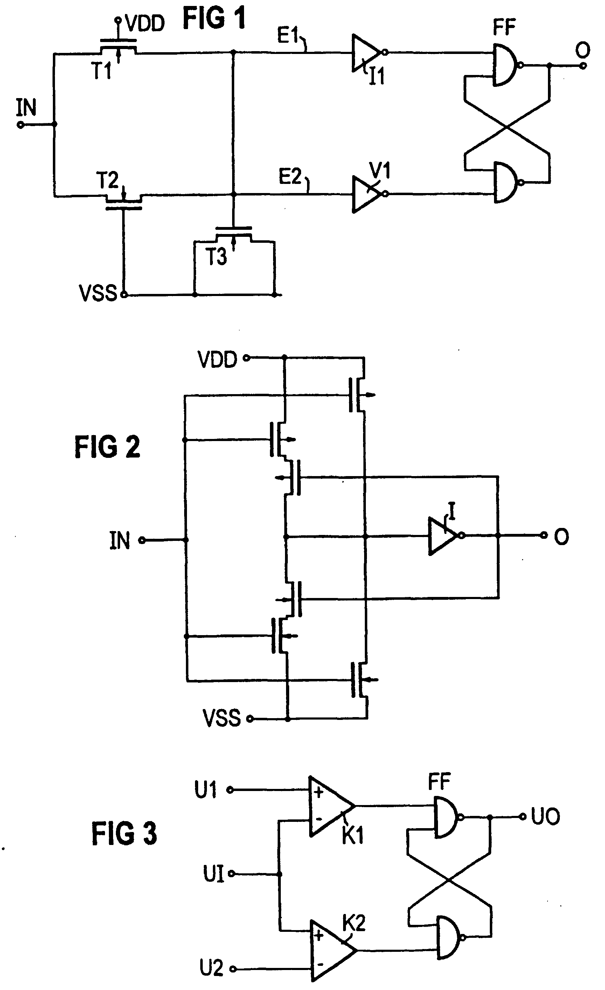

Eine derartige Schaltung ist aus der Veröffentlichung U. Tietze, Ch. Schenk: Halbleiter-Schaltungstechnik, Springer-Verlag, 7. Auflage, 1985, Seite 183 in Verbindung mit einem Präzisions-Schmitt-Trigger bekannt. Bei üblichen Schmitt-Triggern, wie sie beispielsweise in FIG 2 dargestellt sind, besitzen die Umschaltpegel der Hysteresekennlinie nicht die Präzision üblicher Operationsverstärker, da die Ausgangsspannung die Schaltschwellen beeinflußt, aber nicht genau definiert ist. In der genannten Veröffentlichung wird dieser Nachteil dadurch behoben, daß durch zwei Komparatoren die Schaltschwellen festgelegt werden. Die Komparatoren setzen ein RS-Flip-Flop, wenn der obere Schaltpegel überschritten wird und löschen das Flip-Flop, wenn der untere Schaltpegel unterschritten wird. Ein derartiges Prinzipbild ist in FIG 3 dargestellt. Die Eingangsspannung UI wird mit zwei Schaltschwellen U1 und U2 der zwei Komparatoren K1 und K2 verglichen. Die Ausgänge der Komparatoren steuern den Setz- bzw. Rücksetzeingang eines Flip-Flops FF.

Während die Anordnung der FIG 3 gegenüber dem Schmitt-Trigger der FIG 2 dadurch verbessert ist, daß die Schaltschwellen präzise festliegen, ist die Funktion der Schaltung bei Störungen, insbesonderen bei verrauschten Signalen, bei Schwankungen der internen Versorgungsspannung oder bei extern eingekoppelten Signalen nicht zuverlässig gewährleistet. Beispielsweise können die Komparatoren bei einem vorgegebenen Eingangssignal UI und einer kurzzeitigen Verringerung der positiven Versorgungsspannung bzw. einer kurzzeitigen Erhöhung oder Anhebung des Bezugspotentials in ihren Schaltschwellen derart beeinflußt werden, daß einer der Komparatoren bereits durchschaltet, obwohl der Schaltpunkt bei ungestörter Arbeitsweise noch nicht erreicht wäre.

Eine derartige Schaltungsanordnung ist auch aus der GB-A-2 030 404 und der US 4 908 528 bekannt.

Die vorstehend erwähnten Probleme werden erfindungsgemäß durch die in Anspruch 1 beanspruchte Schaltungsanordnung gelöst.

Die Erfindung hat den Vorteil, daß extern wirkende Störungen in Signalrichtung ausgefiltert werden, bevor sie auf die Eingänge der bistabilen Kippschaltung gelangen können und daß interne Störungen gleichtaktmäßig auf die Eingänge der Kippschaltung wirken. Bei einer Realisierung der Schaltungsanordnung in CMOS-Technik, beispielsweise auf einem integrierten Halbleiterchip, können sich Spikes beim Durchschalten der Transistoren nicht oder nur geringfügig auf die gewünschte Funktion der Schaltung auswirken.

Ausgestaltungen der Erfindung sind in Unteransprüchen gekennzeichnet.

Die Erfindung wird nachfolgend anhand eines Ausführungsbeispiels näher erläutert, das in FIG 1 dargestellt ist. Die Figuren 2 und 3 zeigen die bereits beschriebenen Schaltungsanordnungen nach dem Stand der Technik.

Gemäß FIG 1 ist eine Eingangssignalklemme IN mit je einem Anschluß der als Transfergatter dienenden Transistoren T1 bzw. T2 verbunden. T1 wird von der positiven Versorgung VDD und T2 wird von der negativen Versorgung VSS gesteuert. Der andere in Signalrichtung liegende Ausgangsanschluß der Transistoren T1 und T2 sind miteinander verbunden und sind weiterhin mit den Eingängen E1 eines Inverters I1 und E2 eines Verstärkers V2 sowie mit dem Steuereingang eines Transistors T3 verbunden. Die Ausgangsanschlüsse des Transistors T3 sind miteinander und mit dem Versorgungspotential VSS verbunden. Die Ausgangsanschlüsse des Inverters I1 und des Verstärkers V1 steuern je einen Eingang eines Flip-Flops FF aus zwei nicht näher bezeichneten NAND-Gattern, die kreuzweise vom Ausgang zu einem Eingang verkoppelt sind. Ein Ausgang des Flip-Flops ist an der Klemme 0 vorgesehen.

Die als Transfergatter ausgelegten Transistoren T1 und T2 sind hochohmig und wirken somit als Widerstand. Der Transistor T3 ist als Kapazität geschaltet. T1 bis T3 wirken somit als RC-Filter zur Ausfilterung niedriger Frequenzen. Typischerweise wird die Grenzfrequenz dieses Filtergliedes zu etwa 20 MHz eingestellt. Jedoch sind auch je nach Anwendungsfall andere Grenzfrequenzen möglich. Das Ausgangssignal des Tiefpaß-Filters aus den Elementen T1 bis T3 gelangt einerseits auf den Verstärker V1, der beispielsweise eine Schaltschwelle von 1,3 V haben kann und andererseits auf den Eingang des Inverters I1, dessen Schaltschwelle höher als die Schaltschwelle von V1 ist und typischerweise etwa 2,8 V betragen kann. Wird die Schaltschwelle des Verstärkers V1 überschritten, wird der diesem Verstärker nachgeschaltete Eingang des Flip-Flops auf hohes Potential gelegt. Wird andererseits die Schaltschwelle des Inverters I1 überschritten, so wird der Eingang des nachgeschalteten NAND-Gatters des Flip-Flops auf niedriges Potential gesetzt. Damit erfüllt das Flip-Flop eine Funktion, wie sie anhand von FIG 3 bereits erläutert wurde.

Während externe Signalstörungen durch das Tiefpaßfilter mit den Elementen T1 bis T3 ausgefiltert werden, wirken interne Störungen, z. B. des Versorgungsspannungspotentials gleichtaktmäßig auf die Eingänge des Verstärkers und des Inverters. Durch die gleichzeitige Beeinflussung des Schaltverhaltens des Verstärkers bzw. des Inverters aufgrund der internen Störung wird diese Störung damit kompensiert, so daß die Störung keine Auswirkung auf die Funktion der Schaltung hat.

Selbstverständlich können die Transfergatter auch in anderer Weise ausgebildet sein. Die Erfindung eignet sich auch für andere Ausführungsbeispiele als Schmitt-Trigger, z.B. für Reset-Schaltungen.

## Patentansprüche

1. Schaltungsanordnung zur Störsignalunterdrückung, mit einer eine erste Schaltungskomponente (V1) und eine zweite Schaltungskomponente (I1) aufweisenden Schaltung,
- wobei die erste Schaltungskomponente (V1) einen ersten Eingang (E2), und die zweite Schaltungskomponente (I1) einen zweiten Eingang (E1) aufweist,
- wobei die Eingänge (E1, E2) jeweils über ein Transfergatter (T1, T2) mit einer Eingangssignalklemme (IN) der Schaltungsanordnung verbunden sind, und
- wobei parallel zu jedem Eingang (E1, E2) ein als Kapazität geschalteter Transistor (T3) vorgesehen ist,
**dadurch gekennzeichnet,**
- **daß** die erste Schaltungskomponente (V1) eine erste Schaltschwelle aufweist, und ein hohes Potential ausgibt, wenn das ihr über den ersten Eingang (E2) zugeführte Signal über der ersten Schaltschwelle liegt,
- **daß** die zweite Schaltungskomponente (I1) eine zweite Schaltschwelle aufweist, und ein niedriges Potential ausgibt, wenn das ihr über den zweiten Eingang (E1) zugeführte Signal über der zweiten Schaltschwelle liegt, und
- **daß** die erste Schaltschwelle und die zweite Schaltschwelle unterschiedlich groß sind.

2. Schaltungsanordnung nach Anspruch 1,
**dadurch gekennzeichnet,**
**daß** daß der parallel zum ersten Eingang (E1) geschaltete Transistor (T3) und der parallel zum zweiten Eingang (E2) geschaltete Transistor (T3) der selbe Transistor ist.

3. Schaltungsanordnung nach Anspruch 1 oder 2,
**dadurch gekennzeichnet,**
**daß** die Transfergatter (T1, T2) so eingestellt sind, daß sie in Verbindung mit dem als Kapazität geschalteten Transistor (T3) einen Tiefpaß bilden.

## Claims

1. Circuit arrangement for interference signal suppression, having a circuit which has a first circuit component (V1) and a second circuit component (I1),
- where the first circuit component (V1) has a first input (E2) and the second circuit component (I1) has a second input (E1),
- where the inputs (E1, E2) are respectively connected by means of a transfer gate (T1, T2) to an input signal terminal (IN) in the circuit arrangement, and
- where a transistor (T3) connected as a capacitor is provided in parallel with each input (E1, E2),
**characterized**
- **in that** the first circuit component (V1) has a first switching threshold and outputs a high potential when the signal supplied to it via the first input (E2) is above the first switching threshold,
- **in that** the second circuit component (I1) has a second switching threshold and outputs a low potential when the signal supplied to it via the second input (E1) is above the second switching threshold, and
- **in that** the first switching threshold and the second switching threshold have different magnitudes.

2. Circuit arrangement according to Claim 1,
**characterized**
**in that** in that [sic] the transistor (T3) connected in parallel with the first input (E1) and the transistor (T3) connected in parallel with the second input (E2) are the same transistor.

3. Circuit arrangement according to Claim 1 or 2,
**characterized**
**in that** the transfer gates (T1, T2) are set such that they form a low-pass filter in conjunction with the transistor (T3) connected as a capacitor.

## Revendications

1. Arrangement de circuit pour supprimer les signaux parasites, muni circuit qui présente un premier composant de circuit (V1) et un deuxième composant de circuit (I1),
- le premier composant de circuit (V1) présentant une première entrée (E2) et le deuxième composant de circuit (I1) une deuxième entrée (E1),
- les entrées (E1, E2) étant respectivement reliées à une borne d'entrée (IN) de l'arrangement de circuit par le biais d'une porte de transfert (T1, T2), et
- un transistor (T3) branché comme un condensateur étant branché en parallèle avec chaque entrée (E1, E2),
**caractérisé en ce**
- **que** le premier composant de circuit (V1) présente un premier seuil de commutation et délivre un potentiel haut lorsque le signal qui lui est acheminé par le biais de la première entrée (E2) est supérieur au premier seuil de commutation,
- **que** le deuxième composant de circuit (I1) présente un deuxième seuil de commutation et délivre un potentiel bas lorsque le signal qui lui est acheminé par le biais de la deuxième entrée (E1) est supérieur au deuxième seuil de commutation, et
- **que** le premier seuil de commutation et le deuxième seuil de commutation ont des valeurs différentes.

2. Arrangement de circuit selon la revendication 1, **caractérisé en ce que** le transistor (T3) branché en parallèle avec la première entrée (E1) et le transistor (T3) branché en parallèle avec la deuxième entrée (E2) est le même transistor.

3. Arrangement de circuit selon la revendication 1 ou 2, **caractérisé en ce que** les portes de transfert (T1, T2) sont configurées de telle manière qu'en combinaison avec le transistor (T3) branché comme un condensateur, elles forment un filtre passe-bas.
